# EUROPEAN PATENT APPLICATION

(11) **EP 1 641 026 A2**
(43) Date of publication of application: **29.03.2006**
(21) Application number: 05255704.8
(22) Date of filing: 14.09.2005
(51) Int. Cl.: H01L 21/00, B81C 1/00, G02B 26/08

(54) **Method and system for xenon fluoride etching with enhanced efficiency**

(30) Priority: 27.09.2004 US 613423 P; 17.03.2005 US 83030
(71) Applicant: IDC, LLC, San Francisco, CA 94107 (US)
(72) Inventor: Cummings, William J., Millbrae California 94030 (US); Floyd, Philip D., Redwood City California 94062 (US)
(74) Representative: Dunlop, Hugh Christopher

(57) **Abstract**

Provided herein is an apparatus and a method useful for manufacturing MEMS devices. An aspect of the disclosed apparatus provides a substrate comprising an etchable material exposed to a solid-state etchant, wherein the substrate and the solid-state etchant are disposed in an etching chamber. In some embodiments, the solid state etchant is moved into close proximity to the substrate. In other embodiments, a configurable partition is between the substrate and the solid-state etchant is opened. The solid-state etchant forms a gas-phase etchant suitable for etching the etchable material. In some preferred embodiments, the solid-state etchant is solid xenon difluoride. The apparatus and method are advantageously used in performing a release etch in the fabrication of optical modulators.

## Description

### Background of the Invention

### Field of the Invention

The present disclosure relates generally to fabricating electronic devices. More particularly, the disclosure relates to an apparatus and method useful for fabricating a microelectromechanical systems device.

### Description of the Related Art

Microelectromechanical systems (MEMS) include micromechanical elements, actuators, and electronics. Micromechanical elements may be created using deposition, etching, and/or other micromachining processes that etch away parts of substrates and/or deposited material layers or that add layers to form electrical and electromechanical devices. Some of these processes are similar to those originally developed for use in semiconductor manufacturing.

A spatial light modulator is an example of a MEMS. A variety of different types of spatial light modulators can be used for imaging applications. One type of a spatial light modulator is an interferometric modulator. An interferometric modulator may comprise a pair of conductive plates, one or both of which may be partially transparent and capable of relative motion upon application of an appropriate electrical signal. One plate may comprise a stationary layer deposited on a substrate, the other plate may comprise a metallic membrane suspended over the stationary layer. Such devices have a wide range of applications, and it would be beneficial in the art to utilize and/or modify the characteristics of these types of devices so that their features can be exploited in improving existing products and creating new products that have not yet been developed.

### Summary of Certain Embodiments

The system, method, and devices of the invention each have several aspects, no single one of which is solely responsible for its desirable attributes. Without limiting the scope of this invention, its more prominent features will now be discussed briefly. After considering this discussion, and particularly after reading the section entitled "Detailed Description of Certain Embodiments" one will understand how the features of this invention provide advantages that include, for example, improved throughput, control, and process flexibility.

Provided herein is an apparatus and a method useful for manufacturing MEMS devices. An aspect of the disclosed apparatus provides a substrate comprising an etchable material exposed to a solid-state etchant, wherein the substrate and the solid-state etchant are disposed in an etching chamber. In some embodiments, the solid state etchant is moved into close proximity to the substrate. In other embodiments, a configurable partition is between the substrate and the solid-state etchant is opened. The solid-state etchant forms a gas-phase etchant suitable for etching the etchable material. In some preferred embodiments, the solid-state etchant is solid xenon difluoride. The apparatus and method are advantageously used in performing a release etch in the fabrication of optical modulators.

Some embodiments provide an apparatus for etching comprising a chamber, a support for a substrate on which a microelectromechanical systems device is formed, and solid xenon difluoride, wherein the support and the solid xenon difluoride are disposed within the chamber.

Other embodiments disclosed herein provide an apparatus for etching comprising an etchant module and an etching chamber, wherein the etching chamber comprises an interior, an exterior, and a support for a substrate therein, wherein the apparatus has a first configuration, in which the etchant module is disposed in the interior of the etching chamber and is in fluid communication with a substrate disposed on the support, and a second configuration, in which the etchant module is not in fluid communication with the substrate disposed on the support. In some embodiments, the etchant module is movable between a retracted position and an extended position; in the retracted position, the etchant module is substantially outside the etching chamber; and in the extended position the etchant module is substantially within the etching chamber.

Other embodiments provide an apparatus for etching comprising: an etching chamber; a support for a substrate on which microelectromechanical device is formed; an etchant module; and a means for exposing a substrate on the support to the etchant module within the etching chamber.

Other embodiments provide an apparatus for etching comprising a support for a substrate on which a microelectromechanical systems device is formed and solid xenon difluoride, wherein the support and the solid xenon difluoride are proximate for a vapor formed from the solid xenon difluoride to etch a substrate comprising an etchable material.

Other embodiments disclosed herein provide a method for fabricating a microelectromechanical systems device and a microelectromechanical systems device fabricated according to the method, wherein the method comprises: supporting a substrate in an etching chamber comprising an interior, an exterior, and a support for a substrate; and disposing an etchant module in the interior of the etchant chamber and in fluid communication with the substrate, wherein a solid-state etchant is supported in the etchant module. In some embodiments, the microelectromechanical systems device is an interferometric modulator.

Other embodiments provide a method for fabricating a microelectromechanical systems device and a microelectromechanical systems device fabricated according to the method, wherein the method comprises: disposing within an etching chamber a substrate comprising an etchable material, and disposing within the etching chamber a solid etchant, wherein the solid etchant forms a gas-phase etchant capable of etching the etchable material.

Other embodiments provide a method for fabricating a microelectromechanical systems device and a microelectromechanical systems device fabricated according to the method, wherein the method comprises: disposing a substrate within an etching chamber; extending an etchant module into the etching chamber; and allowing the gas-phase etchant to etch the material. A solid etchant is supported on the etchant module, and the solid etchant forms a gas-phase etchant capable of etching a material on the substrate.

Other embodiments provide a method for fabricating a microelectromechanical systems device and a microelectromechanical systems device fabricated according to the method, wherein the method comprises: providing solid xenon difluoride within an etch chamber; supporting a substrate comprising an etchable material within the etch chamber; and etching the etchable material from the substrate with a vapor generated by the solid xenon difluoride.

Other embodiments provide a method for fabricating a microelectromechanical systems device and a microelectromechanical systems device fabricated according to the method, wherein the method comprises: supporting a substrate comprising an etchable material within the etch chamber; and positioning solid xenon difluoride sufficiently proximate to the substrate such that a vapor formed by the solid xenon difluoride etches the etchable material.

Other embodiments provide an apparatus for etching comprising means for housing a substrate to be etched. The apparatus further comprises means for supporting the substrate. The apparatus further comprises means for supporting an etchant. The apparatus further comprises means for positioning the substrate supporting means and the etchant supporting means in close proximity within the housing means.

Other embodiments provide an apparatus for etching comprising an etching chamber and a etchant module, wherein the etchant module is movable between a retracted position and an extended position. In the retracted position, the etchant module is substantially outside the etching chamber, and in the extended position the etchant module is substantially within the etching chamber.

### Brief Description of the Drawings

These and other aspects of the invention will be readily apparent from the following description and from the appended drawings (not to scale), which are meant to illustrate and not to limit the invention.
**FIG. 1** is an isometric view depicting a portion of one embodiment of an interferometric modulator display in which a movable mirror of a first interferometric modulator is in a reflective, or "on," position at a predetermined distance from a fixed mirror and the movable mirror of a second interferometric modulator is in a non-reflective, or "off" position.
**FIG. 2** is a system block diagram illustrating one embodiment of an electronic device incorporating a 3 × 3 interferometric modulator display.
**FIG. 3** is a diagram of movable mirror position versus applied voltage for one exemplary embodiment of an interferometric modulator of **FIG. 1**.
**FIG. 4** is an illustration of sets of row and column voltages that may be used to drive an interferometric modulator display.
**FIG. 5A** and **FIG. 5B** illustrate one exemplary timing diagram for row and column signals that may be used to write a frame of display data to the 3 × 3 interferometric modulator display of **FIG. 3**.
**FIG. 6A** is a cross section of the device of **FIG. 1. FIG. 6B** is a cross section of an alternative embodiment of an interferometric modulator. **FIG. 6C** is a cross section of an alternative embodiment of an interferometric modulator
**FIG. 7A-FIG. 7E** illustrate in cross section certain intermediate structures in the fabrication of an embodiment of an interferometric modulator.
**FIG. 8** illustrates an embodiment of an apparatus useful for performing a release etch in the fabrication of a MEMS device.
**FIG. 9** is a flowchart illustrating an embodiment of a method for performing a release etch using the apparatus of **FIG.** 8.
**FIG. 10A** is a perspective view of an embodiment of an apparatus suitable for performing a release etch in the fabrication of a MEMS device. **FIG. 10B** and **FIG. 10C** are detail views of a module for the apparatus illustrated in **FIG. 10A, FIG. 10D** and **FIG. 10E** are top views and cross sections, respectively, of another embodiment of an etching chamber.
**FIG. 11A-FIG. 11D** illustrate alternative embodiments for an etchant module.
**FIG. 12A** and **FIG.12B** illustrate alternative embodiments for etching chambers.
**FIG. 13** is a flowchart illustrating an embodiment of a method for performing a release etch using the apparatus illustrated in **FIG. 10A** or **FIG. 12A.**

### Detailed Description of Certain Embodiments

As described in more detail below, preferred embodiments disclosed herein provide an etching chamber comprising a support for a MEMS substrate and a solid etchant disposed within the etching chamber. In some embodiments, the solid etchant is supported in a module that is movable between a position distal of the support for the MEMS substrate and a position proximal of the support. In other embodiments, a configurable partition between the MEMS substrate and the solid etchant is opened. In some preferred embodiments, the solid etchant is xenon difluoride. Also described herein are embodiments of methods of using the apparatus in the fabrication of a MEMS device, and in particular, an interferometric modulator. These and other embodiments are described in greater detail below.

The following detailed description is directed to certain specific embodiments of the invention. However, the invention can be embodied in a multitude of different ways. In this description, reference is made to the drawings wherein like parts are designated with like numerals throughout. As will be apparent from the following description, the invention may be implemented in any device that is configured to display an image, whether in motion (e.g., video) or stationary (e.g., still image), and whether textual or pictorial. More particularly, it is contemplated that the invention may be implemented in or associated with a variety of electronic devices such as, but not limited to, mobile telephones, wireless devices, personal data assistants (PDAs), hand-held or portable computers, GPS receivers/navigators, cameras, MP3 players, camcorders, game consoles, wrist watches, clocks, calculators, television monitors, flat panel displays, computer monitors, auto displays (e.g., odometer display, etc.), cockpit controls and/or displays, display of camera views (e.g., display of a rear view camera in a vehicle), electronic photographs, electronic billboards or signs, projectors, architectural structures (e.g., tile layouts), packaging, and aesthetic structures (e.g., display of images on a piece of jewelry). More generally, the invention may be implemented in electronic switching devices.

Spatial light modulators used for imaging applications come in many different forms. Transmissive liquid crystal display (LCD) modulators modulate light by controlling the twist and/or alignment of crystalline materials to block or pass light. Reflective spatial light modulators exploit various physical effects to control the amount of light reflected to the imaging surface. Examples of such reflective modulators include reflective LCDs, and digital micromirror devices.

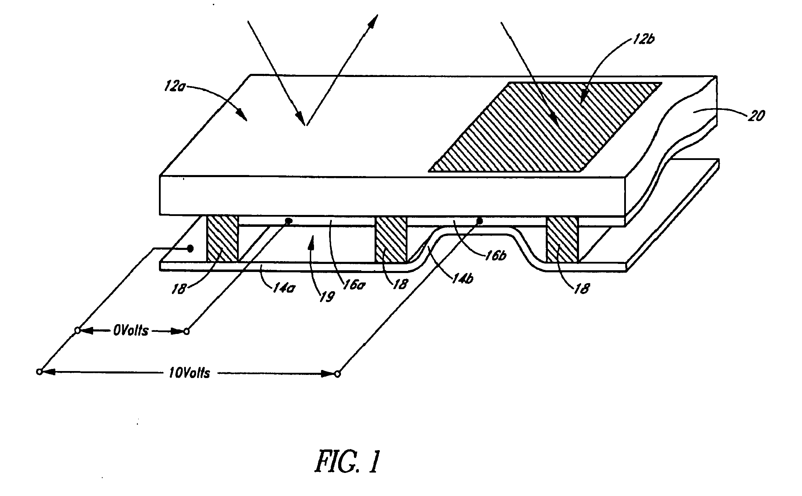

Another example of a spatial light modulator is an interferometric modulator that modulates light by interference. One interferometric modulator display embodiment comprising a reflective MEMS display element is illustrated in **FIG. 1**. In these devices, the pixels are in either a bright or dark state. In the bright ("on" or "open") state, a bi-stable display element reflects incident light to a user. When in the dark ("off" or "closed") state, a bi-stable display element and reflects little visible light to the user. Depending on the embodiment, the display110 may be configured to reflect more visible light in the "off" state than in the "on" state, i.e., the light reflectance properties of the "on" and "off" states are reversed. MEMS pixels can also be configured to reflect only selected colors, producing a color display rather than black and white.

**FIG. 1** is an isometric perspective view depicting two adjacent pixels in a row of one embodiment of a visual display, comprising a MEMS interferometric modulator. An interferometric modulator display comprises a row/column array of these interferometric modulators. Each interferometric modulator includes a pair of mirrors positioned at a distance from each other to form a resonant optical cavity. In one embodiment, at least one of the mirrors in partially transmissive. In one embodiment, one of the mirrors may be moved between at least two positions. In the first position, the movable mirror is positioned at a first distance from the other mirror so that the interferometric modulator is predominantly reflective. In the second position, the movable mirror is positioned at a different distance, e.g., adjacent to the fixed mirror, such that the interferometric modulator is predominantly absorbing.

The depicted portion of the pixel array includes two adjacent interferometric modulators **12***a* and **12***b* in a row. In the depicted embodiment of the interferometric modulator, a movable mirror **14***a* is illustrated in the reflective ("relaxed", "on", or "open") position at a predetermined distance from a fixed, partial mirror **16***a*, **16***b*. The movable mirror **14***b* of the interferometric modulator **12***b* is illustrated in the non-reflective ("actuated", "off", or "closed") position adjacent to the partial mirror **16***b*.

The fixed mirrors **16***a*, **16***b* are electrically conductive, and may be fabricated, for example, by depositing layers of chromium and indium-tin-oxide onto a transparent substrate**18** that are patterned into parallel strips, and may form row electrodes. The movable mirrors **14***a*, **14***b* along the row may be formed as a series of parallel strips of a deposited metal layer or layers (orthogonal to the row electrodes **16***a*, **16***b*) on the substrate 18, with aluminum being one suitable material, and may form column electrodes.

With no applied voltage, a cavity **19** exists between the two layers **14, 16.** However, when a potential difference is applied to a selected row and column, the capacitor formed at the intersection of the row and column electrodes at the corresponding pixel charges, and electrostatic forces pull the electrodes together. If the voltage is high enough, the movable electrode is forced against the stationary electrode (a dielectric material may be deposited on the stationary electrode to prevent shorting and control the separation distance) as illustrated by the pixel on the right in **FIG. 1**. The behavior is the same regardless of the polarity of the applied potential difference. In this way, row/column actuation can control the reflective vs. non-reflective state of each pixel.

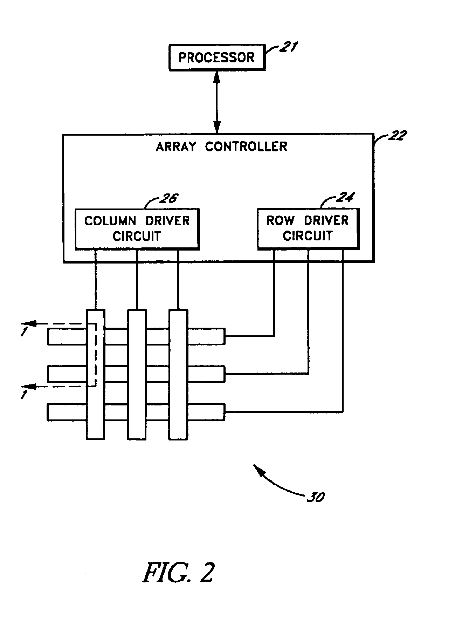

**FIG. 2** through **FIG. 5** illustrate one exemplary process and system for using an array of interferometric modulators in a display application. **FIG. 2** is a system block diagram illustrating one embodiment of an electronic device that may incorporate aspects of the invention. In the exemplary embodiment, the electronic device includes a processor **20** which may be any general purpose single- or multi-chip microprocessor such as an ARM, Pentium®, Pentium II®, Pentium III®, Pentium IV®, Pentium® Pro, an 8051, a MIPS®, a Power PC®, an ALPHA®, or any special purpose microprocessor such as a digital signal processor, microcontroller, or a programmable gate array. As is conventional in the art, the processor **20** may be configured to execute one or more software modules. In addition to executing an operating system, the processor may be configured to execute one or more software applications, including a web browser, a telephone application, an email program, or any other software application.

In one embodiment, the processor **20** is also configured to communicate with an array controller **22**. In one embodiment, the array controller **22** includes a row driver circuit **24** and a column driver circuit **26** that provide signals to the array **30**. The cross section of the array illustrated in **FIG. 1** is shown by the lines 1-1 in **FIG. 2.** Portions of the array controller 22 as well as additional circuitry and functionality may be provided by a graphics controller which is typically connected between the actual display drivers and a general purpose microprocessor. Exemplary embodiments of the graphics controller include 69030 or 69455 controllers from Chips and Technology, Inc., the S1D1300 series from Seiko Epson , and the Solomon Systech 1906.

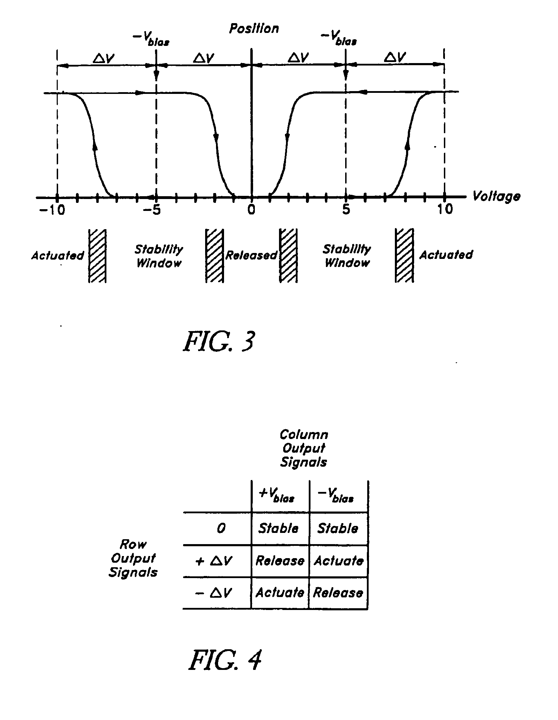

For MEMS interferometric modulators, the row/column actuation protocol may take advantage of a hysteresis property of these devices illustrated in **FIG. 3**. It may require, for example, a 10 volt potential difference to cause a pixel to deform from the relaxed state to the actuated state. However, when the voltage is reduced from that value, the pixel may not relax until the voltage drops below 2 volts. There is thus a range of voltage, about 3 V to about 7 V in the example illustrated in **FIG. 3**, where there exists a stability window within which the device will remain in whatever state it started in. The row/column actuation protocol is therefore designed such that during row strobing, pixels in the strobed row that are to be actuated are exposed to a voltage difference of about 10 volts, and pixels that are to be relaxed are exposed to a voltage difference of close to zero volts. After the strobe, the pixels are exposed to a steady state voltage difference of about 5 volts such that they remain in whatever state the row strobe put them in. After being written, each pixel sees a potential difference within the "stability window" of 3-7 volts in this example. This feature makes the pixel design illustrated in **FIG. 1** stable under the same applied voltage conditions in either an actuated or relaxed pre-existing state. Since each pixel of the interferometric modulator, whether in the actuated or relaxed state, is essentially a capacitor formed by the fixed and moving mirrors, this stable state can be held at a voltage within the hysteresis window with almost no power dissipation. Essentially no current flows into the pixel if the mirror is not moving and the applied potential is fixed.

In typical applications, a display frame may be created by asserting the set of column electrodes in accordance with the desired set of actuated pixels in the first row. A row pulse is then applied to the row 1 electrode, actuating the pixels corresponding to the asserted column lines. The asserted set of column electrodes is then changed to correspond to the desired set of actuated pixels in the second row. A pulse is then applied to the row 2 electrode, asserting the appropriate pixels in row 2 in accordance with the asserted column electrodes. The row I pixels are unaffected by the row 2 pulse, and remain in the state they were set to during the row 1 pulse. This may be repeated for the entire series of rows in a sequential fashion to produce the frame. Generally, the frames are refreshed and/or updated with new display data by continually repeating this process at some desired number of frames per second. A wide variety of other protocols for driving row and column electrodes of pixel arrays to produce display frames are also well known and may be used in conjunction with the present invention.

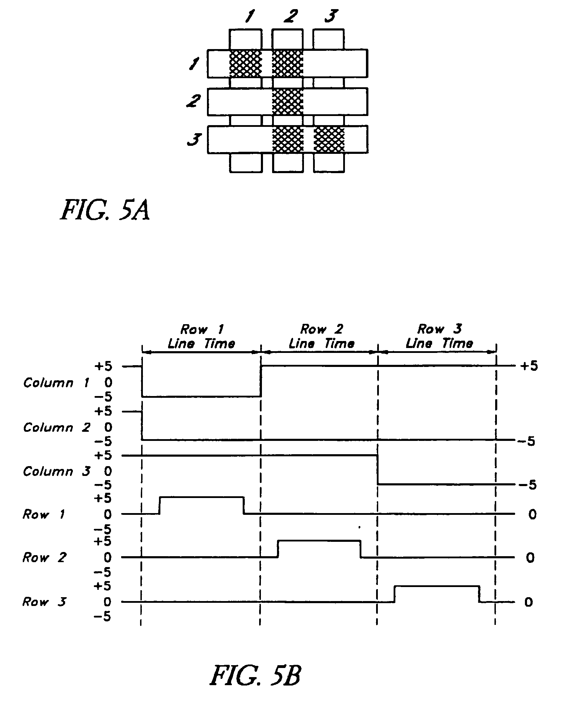

**FIG. 4** and **FIG. 5** illustrate one possible actuation protocol for creating a display frame on the 3 × 3 array of **FIG. 2. FIG. 4** illustrates a possible set of column and row voltage levels that may be used for pixels exhibiting the hysteresis curves of **FIG. 3**. In the **FIG. 4** embodiment, actuating a pixel involves setting the appropriate column to -V_{bias}, and the appropriate row to +ΔV. Relaxing the pixel is accomplished by setting the appropriate column to +V_{bias}, and the appropriate row to the same +ΔV. In those rows where the row voltage is held at zero volts, the pixels are stable in whatever state they were originally in, regardless of whether the column is at +V_{bias}, or -V_{bias.}

**FIG. 5B** is a timing diagram showing a series of row and column signals applied to the 3 × 3 array of Figure 2 which will result in the display arrangement illustrated in **FIG. 5A**, where actuated pixels are non-reflective. Prior to writing the frame illustrated in **FIG. 5A**, the pixels can be in any state, and in this example, all the rows are at 0 volts, and all the columns are at +5 volts. In this state, all pixels are stable in their existing actuated or relaxed states.

In the **FIG. 5A** frame, pixels (1,1), (1,2), (2,2), (3,2) and (3,3) are actuated. To accomplish this, during a "line time" for row 1, columns 1 and 2 are set to-5 volts, and column 3 is set to +5 volts. This does not change the state of any pixels, because all the pixels remain in the 3-7 volt stability window. Row 1 is then strobed with a pulse that goes from 0, up to 5 volts, and back to zero. This actuates the (1,1) and (1,2) pixels and relaxes the (1,3) pixel. No other pixels in the array are affected. To set row 2 as desired, column 2 is set to -5 volts, and columns I and 3 are set to +5 volts. The same strobe applied to row 2 will then actuate pixel (2,2) and relax pixels (2,1) and (2,3). Again, no other pixels of the array are affected. Row 3 is similarly set by setting columns 2 and 3 to -5 volts, and column 1 to +5 volts. The row 3 strobe sets the row 3 pixels as shown in Figure 5A. After writing the frame, the row potentials are zero, and the column potentials can remain at either +5 or -5 volts, and the display is then stable in the arrangement of **FIG. 5A.** It will be appreciated that the same procedure can be employed for arrays of dozens or hundreds of rows and columns. It will also be appreciated that the timing, sequence, and levels of voltages used to perform row and column actuation can be varied widely within the general principles outlined above, and the above example is exemplary only, and any actuation voltage method can be used with the present invention.

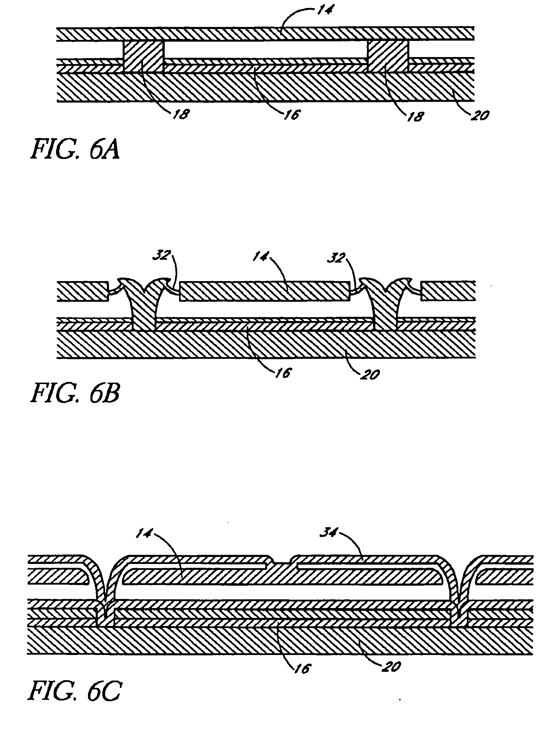

The details of the structure of interferometric modulators that operate in accordance with the principles set forth above may vary widely. For example, **FIG. 6A-FIG. 6C** illustrate three different embodiments of the moving mirror structure. **FIG. 6A** is a cross section of the embodiment of **FIG. 1,** where a strip of metal material **14** is deposited on orthogonally extending supports **18.** In **FIG. 6B,** the moveable mirror is attached to the supports at the corners only, on tethers **32.** In **FIG. 6C,** the mirror **14** is suspended from a deformable film **34.** This embodiment has benefits because the structural design and materials used for the mirror **14** can be optimized with respect to the optical properties, and the structural design and materials used for the deformable layer **34** can be optimized with respect to desired mechanical properties. The production of various types of interferometric devices is described in a variety of published documents, including, for example, U.S. Published Application 2004/0051929 A1. A wide variety of well known techniques may be used to produce the above described structures involving a series of material deposition, patterning, and etching steps.

Interferometric modulators of the general designs described above and disclosed in U.S. Patent No. 5,835,255 and in U.S. Patent Publication No. 2004/0051929, the disclosures of which are incorporated by reference, and those illustrated in **FIG. 6A-FIG. 6C** include a cavity **19** between the mirrors **14** and **16** through which the mirror **14** moves with respect to the mirror **16.** In some embodiments, the cavity **19** is created by forming a sacrificial layer that is removed in a latter stage in the processing, as described in greater detail below.

U.S. Provisional App. No. 60/613466 entitled "Device and Method for Interferometric Modulation Having Oxide-Stops" filed on September 27, 2004, the disclosure of which is incorporated by reference, also discloses manufacturing techniques for the fabrication of an interferometric modulator. A sacrificial layer is formed and etched away to release the secondary mirror/conductor from the primary mirror/conductor, thereby forming a cavity and permitting movement therebetween. This etch is also referred to herein as a "release etch," because the flexible membrane is released by the etch thereby permitting flexure of this membrane.

As discussed more fully below, in some preferred embodiments, solid XeF₂ is a source of a gas-phase etchant used in the release etch. As such, the following description refers to solid XeF₂ as the source of the gas-phase etchant, although those skilled in the art will understand that the disclosure is not so limited. Methods and apparatus for enhancing the efficiency of the XeF₂ release etch are also described more fully below. As discussed in greater detail below, materials etchable by XeF₂ include materials comprising silicon, titanium, zirconium, hafnium, vanadium, tantalum, niobium, molybdenum, and tungsten.

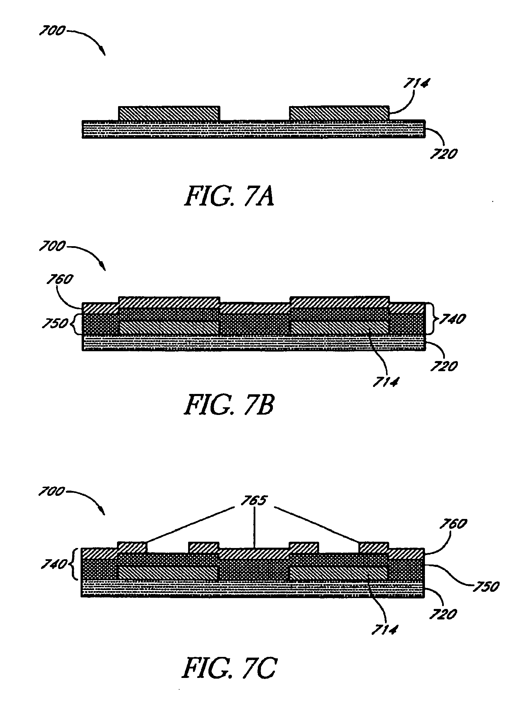

A brief description of certain steps in the fabrication of an embodiment of an interferometric modulator follows, and is illustrated schematically in cross section in **FIG. 7A-FIG. 7E**. Some embodiments of the illustrated process use semiconductor manufacturing techniques known in the art, for example photolithography, deposition, masking, etching, and the like. Deposition steps include "dry" methods, for example, chemical vapor deposition (CVD), and "wet" methods, for example, spin coating. Etching steps include "dry" methods, for example, plasma etch, and "wet" methods. Those skilled in the art will understand that a range of methods are useful in the fabrication of the optical modulator, and that the process described below is only exemplary.

**FIG. 7A** illustrates a stage in the fabrication of a interferometric modulator **700** in which an optical stack is formed on a substrate **720.** The optical stack comprises the fixed or primary mirror **714** discussed above. In some embodiments, the optical stack further comprises a transparent conductor, for example, an indium tin oxide layer, and/or a supporting layer, for example, a silicon oxide layer. Some embodiments comprise a metallic mirror, for example, chromium, aluminum, titanium, and/or silver. Other embodiments comprise a dielectric mirror. The optical stack is formed by methods known in the art, for example, deposition, patterning, and etching.

In **FIG. 7B,** a supporting layer **740** has been formed over the optical stack and substrate **720.** In the illustrated embodiment, the supporting layer **740** comprises a lower or "bulk" portion **750** and an upper layer or "stop" portion **760.** The lower portion **750** comprises a material that is removable in a later etching step, for example, molybdenum, silicon, a silicon-containing material (*e.g.*, silicon nitride, silicon oxide, etc.), tungsten, and/or titanium. The upper portion **760** comprises a material that resists the etchant used to etch the lower portion **750,** for example, a metal such as aluminum, silver, chromium, and/or titanium. In some embodiments, the upper portion **760** comprises a dielectric material, for example, a metal oxide and/or aluminum oxide. In some embodiments, the lower portion **750** and upper portion **760** is graded. Some embodiments do not comprise a supporting layer.

**FIG. 7C** illustrates a stage in the fabrication of the device **700** in which the upper portion **760** of the supporting layer has been patterned and etched to form a variable thickness supporting layer **765,** as well as to expose sections of the lower portion **750** of the supporting layer. The patterning is performed using any method known in the art, for example, using a photoresist. In the illustrated embodiment, unmasked regions of the upper portion **760** of the supporting layer were etched, while substantial portions of the lower portion **750** were not.

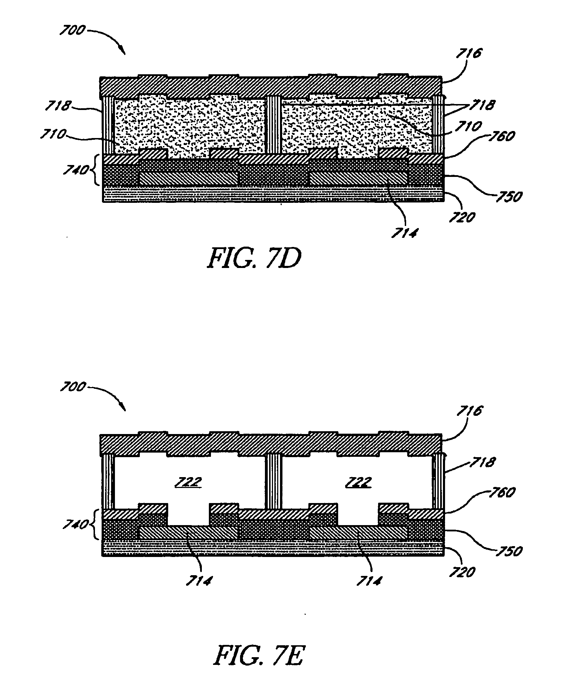

**FIG. 7D** illustrates a stage in which a sacrificial layer **710** has been deposited on the supporting layer **740.** The sacrificial layer was patterned, etched, and planarized, and support posts **718** formed therein. A second mirror/upper electrode assembly **716** was formed over the sacrificial layer **710** and posts **718** by deposition, patterning, and etching. The sacrificial layer **710** comprises a material that is selectively etchable relative to the other materials exposed to a selected etchant. Suitable materials and etchants are discussed in greater detail below. In some preferred embodiments, the sacrificial layer **710** comprises molybdenum and/or silicon.

**FIG. 7E** illustrates the device **700** after etching the sacrificial layer **710.** This etch step is referred to herein as a "sacrificial etch" and/or a "release etch." Methods and procedures for performing a release etch are discussed in greater detail below. In the illustrated embodiment, parts of the lower portion **750** of the supporting layer were also etched. In some embodiments, the lower portion **750** is partially etched or not etched at all. In other embodiments, the supporting layer **740** does not comprise a lower portion **750.** In the illustrated embodiment, removal of the sacrificial layer **710** and portions of the lower portion **750** of the supporting layer forms a cavity **722.** Suitable etchants are discussed in greater detail below. In some preferred embodiments, the etchant used in the sacrificial and/or release etch comprises xenon difluoride. Without being bound by any theory, XeF₂ is believed to be a source of F₂ gas, which is the active etching species.

At ordinary temperatures and pressures, XeF₂ is a crystalline solid that sublimes with a vapor pressure of about 3.8 Torr at room temperature (0.5 kPa at 25 °C). XeF₂ vapor etches certain materials without the need to generate a plasma. Materials etchable using XeF₂ vapor include silicon, molybdenum, and titanium, which are selectively etched over other materials including silicon dioxide (SiO₂), aluminum oxide (Al₂O₃), aluminum, and chromium. At ambient temperature, XeF₂ has a vertical etch rate of about 50 Å/s for molybdenum and about 350 Å/s for silicon. In comparison, SiO₂, Al, and Al₂O₃ are substantially not etched by XeF₂. Etch rates are known in the art, as disclosed, for example, in *IEEE J. Microelectromech. Syst.,* **1996**, *5*(*4*), 262; *IEEE J. Microelectromech. Syst.,* **1996,** *12*(*6*), 761. In some embodiments, the partial pressure of the XeF₂ is from about 0.1 torr (13 Pa) to about 10 torr (1.3 kPa). Process temperatures range from ambient temperature to about 100 °C.

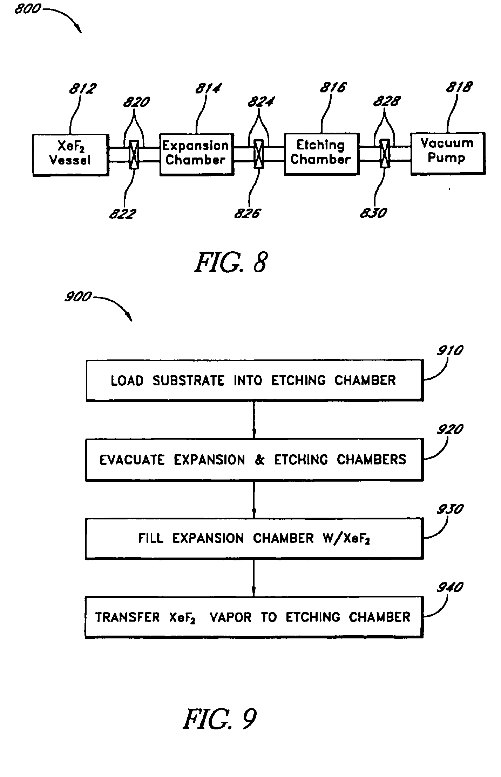

**FIG. 8** illustrates an apparatus **800** useful for implementing a XeF₂ etching step. The apparatus **800** comprises a XeF₂ vessel **812** in which XeF₂ crystals are housed, an expansion chamber **814,** an etching chamber **816,** and a vacuum source **818.** The XeF₂ vessel **812** is fluidly connected to the expansion chamber 814 through a first conduit **820** and a first valve **822.** The expansion chamber **814** is in turn fluidly connected to the etching chamber **816** through a second conduit **824** and a second valve **826.** The etching chamber **816** is fluidly connected to the vacuum source **818** through a third conduit **828** and a third valve **830.**

**FIG. 9** illustrates a method **900** for etching a substrate using XeF₂ with reference to the apparatus illustrated in **FIG. 8.** In step **910,** a substrate or batch of substrates to be etched (not illustrated), is loaded into the etching chamber **816.**

In step **920,** the second and third valves **826** and **830** are opened, fluidly connecting the expansion chamber **814** and etching chamber **816** to the vacuum source **818,** thereby evacuating the expansion chamber **814** and etching chamber **816.** In step **920,** the first valve **822** between the XeF₂ vessel **812** and the expansion chamber **814** remains closed.

In step **930,** the second valve **826** is closed, and the first valve **822** is opened. Opening the first valve **822** permits XeF₂ vapor to fill the expansion chamber **814** from the XeF₂ vessel **812.**

In step **940,** the second valve **826** between the expansion chamber **814** and the etching chamber **816** is opened, and the first and third valves **822** and **830** are closed. Opening the second valve **826** permits transfers XeF₂ from the expansion chamber **814** to the etching chamber **816,** which etches the substrate(s) therein.

Steps **910-930,** in which no etching occurs, take time, thereby reducing the throughput of the apparatus **800.** In some embodiments, the conduits (**820,824,** and **828**) and valves (**822, 826,** and **828**) fluidly connecting the XeF₂ vessel **812,** expansion chamber **814,** etching chamber **816,** and vacuum source **818** also reduce one or more mass and/or fluid transport characteristics of the apparatus **800.**

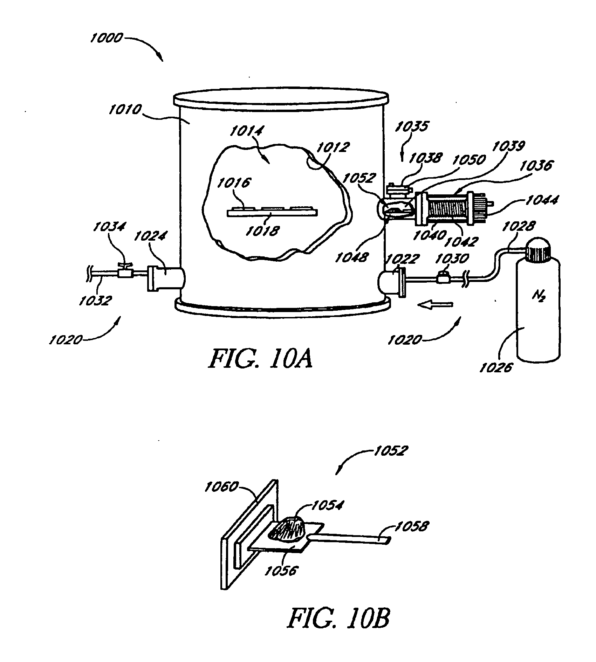

An embodiment of an apparatus **1000** illustrated in **FIG. 10A-FIG. 10C** permits solid XeF₂ and the substrate-to-be-etched to reside in close proximity within the same chamber during the etching step. **FIG. 10A** illustrates an etching chamber **1010** comprising inner sidewalls **1012** defining a central or main cavity **1014** therein. **FIG. 10A** includes a cut-away view of the chamber **1010** showing a plurality of substrates-to-be-etched 1016 disposed on a substrate support **1018,** within the central cavity **1014.** In the illustrated embodiment, the etching chamber **1010** is substantially cylindrical; however, those skilled in the art will understand that the etching chamber **1010** can have any suitable shape.

**FIG. 10D** illustrates a top view of an embodiment of an etching chamber **1010'** in which the inner sidewalls **1012'** of the etching chamber substantially match the size and shape of the substrate support **1018'**, which is in turn, substantially similar to the size and shape of the substrate **1016'**. In the illustrated embodiment, the substrate is substantially rectangular. Those skilled in the art will understand that other configurations are possible. **FIG. 10E** is a cross section view of the etching chamber **1010'**. In the illustrated embodiment, the top of the etching chamber **1013'** along with the sidewalls **1012'** defines the central cavity **1014'**. In some embodiments, the geometry of the central cavity **1014'** is configured to improve the efficiency of the etching step performed therein. For example, in the illustrated embodiment, if the distance between the top of the etching chamber **1013'** and the substrate **1016'** is relatively small, the volume of the etching chamber **1014'** is insufficient to hold a sufficient amount of etchant, for example, XeF₂ vapor, to efficiently etch the substrate **1016'.** On the other hand, if the distance between the top of the etching chamber **1013'** and the substrate **1016'** is relatively large, XeF₂ vapor from near the top **1013'** will take a significant time to diffuse to the substrate 1016'. The etching chamber **1010'** illustrated in **FIG. 10D** and **FIG. 10E** is configured for etching a single substrate at a time. In other embodiments, the etching chamber is configured for processing a plurality of substrates simultaneously. Those skilled in the art will understand that the dimensions of the etching chamber will depend on factors including the sizes of the substrate or substrates, the amount of material to be etched, the nature of other processes that are performed in the etching chamber. In some embodiments, the lateral dimensions, *e.g.*, the length and width, of the etching chamber are up to about 20% larger than the size of the substrate. For example, some embodiments provide an etching chamber **1010'** with a length and/or width of from greater than about 100 mm to about 120 mm for a 100-mm diameter substrate. Other embodiments provide for a 370-mm × 470-mm substrate, an etching chamber **1010'** with dimensions of from greater than about 370 mm to about 450 mm, by from greater than about 470 mm to about 570 mm. In some embodiments, the lateral dimensions, *e.g.*, the length and width, of the etching chamber are up to about 10% larger than the size of the substrate.

Referring back to **FIG.10A-FIG. 10C,** the etching chamber **1010** optionally includes one or more other components useful for performing other processing tasks, for example, deposition, patterning, etching, testing, packaging, and the like (not illustrated). In some embodiments, the substrate holder **1018** includes optional features, including, for example, a heater, one or more translation stages, and/or other features known in the art useful in processing the substrate(s) **1016.**

In some embodiments, the inner sidewalls **1012** of the etching chamber **1010** and/or the components enclosed therein comprise one or more materials that are not etched or are minimally etched by XeF₂. Such materials include without limitation, stainless steel, aluminum, nickel, nickel alloys, monel, hastelloy, glass, fused silica, alumina, sapphire, polymer resins, acrylic, polycarbonate, polytetrafluoroethylene (Teflon®), polychlorotrifluoroethylene (Kel-F®, Tefzel®), perfluoroelastomers (*e.g.*, Kalrez®), and alloys, blends, copolymers, and composites thereof. Components include windows, the substrate stage **1018,** and other components that are described below. In some embodiments, other materials are used. For example, in some embodiments, one or more of the components is affected by XeF₂ and is disposable and/or replaceable.

Returning to **FIG. 10A,** the illustrated apparatus **1000** also comprises a purge system **1020** fluidly connected to the etching chamber **1010** through a purge inlet **1022** and a purge outlet **1024.** A source of purge gas **1026** is fluidly connected to the purge inlet **1022** through line **1028** and an inlet valve **1030.** The purge gas is any suitable purge gas known in the art, for example, nitrogen, helium, argon, neon, and combinations thereof. The source of purge gas is any source known in the art, for example, a compressed gas cylinder, a gas generator, a liquefied gas, and the like. In some embodiments, the purge gas comprises another gas. The purge outlet **1024** is fluidly connected to a vacuum source (not illustrated) through outlet valve **1034** and line **1032.** In some embodiments, the purge system does not comprise a purge outlet. For example, in some of these embodiments, the inlet valve **1030** and the outlet valve **1034** are fluidly connected to a manifold (not illustrated), and the manifold is fluidly connected to the purge inlet **1022.**

The apparatus **1000** is also equipped with a opening (not illustrated) through which the substrates **1016** are loaded and unloaded from the apparatus **1000.** The opening is of any type known in the art, for example, a gate valve between the etching chamber **1010** and a handling chamber (not illustrated).

In the illustrated embodiment, a solid etchant, for example, solid XeF₂, is held in an etchant holding unit **1035** mounted to the etching chamber **1010.** The illustrated apparatus **1000** comprises one etchant holding unit **1035.** Other embodiments comprise a plurality of etchant holding units. In the illustrated embodiment, etchant unit **1035** is equipped with a translation device **1036** that comprises rails **1040,** bellows **1042,** and a threaded shaft (not illustrated) engaging a threaded coupler (not illustrated) and a rotatable control **1044.** The illustrated translation device **1036** further comprises an arm (not illustrated) disposed within the bellows **1042.** Rotating the rotatable control **1044** rotates the threaded shaft in the threaded coupler, thereby translating (extending or retracting) the arm. In the illustrated embodiment, the bellows **1042** is compressed or expanded to accommodate the translation. Those skilled in the art will understand that other mechanisms are useful for the translation device **1036,** for example, a pantograph, a rack and pinion, a piston and cylinder, a rail, and the like. Other mechanisms include motors, stepper motors, solenoids, pneumatics, and/or hydraulic devices. In other embodiments, the motion is rotational, as described in greater detail below, or has another type of motion known in the art. In some embodiments, the translation device **1036** is automated, for example, controlled using a computer and/or microprocessor (not illustrated). In some embodiment, the computer and/or microprocessor controls also other functions of the apparatus, for example, the purge system, substrate loading, substrate unloading, and/or loading solid XeF₂.

The etchant holding unit **1035** comprises an access port **1038.** The access port **1038** comprises a passageway therethrough that opens into an open inner region **1039** therein. In the illustrated embodiment, the access port **1038** also includes a door **1050** that provides access to the inner region **1039** of the access port. In some embodiments, the door **1050** is automated, thereby permitting automated loading of XeF₂. In the illustrated embodiment, solid XeF₂ is loaded into the XeF₂ unit **1035** through the door **1050.** In some embodiments, the open inner region **1039** is fluidly connected to a purge system, for example, a source of purge gas and/or a vacuum source (not illustrated). The purge system is useful, for example, when solid XeF₂ is loaded into the XeF₂ unit 1035.

Also illustrated in **FIG. 10A** through a cutaway in the access port **1038** is a module **1052** for supporting solid XeF₂. An enlarged view of the module **1052** is provided in **FIG. 10B.** In the illustrated embodiment, the module **1052** includes a platform **1056** that supports a solid XeF₂ sample **1054.** The platform **1056** is secured to a rod **1058,** which is in turn secured to the arm of the translation device **1036.** Accordingly, the translation device **1036** is capable of longitudinally positioning the module **1052** on which the solid XeF₂ **1054** is supported.

In **FIG. 10A**, the module **1052** is in a retracted position, within the inner region **1039** of the access port **1038.** The module **1052** is not disposed in the central cavity **1014** of the chamber **1010.** In the illustrated configuration, the access port **1038** is isolated from the central cavity **1014** of the chamber **1010** such that vapor from the solid XeF₂ **1054** is substantially contained within the access port **1038** and does not enter the central cavity **1014** of the chamber **1010.** In the illustrated retracted position, solid XeF₂ **1054** is loaded on the module **1052** through the door **1050.**

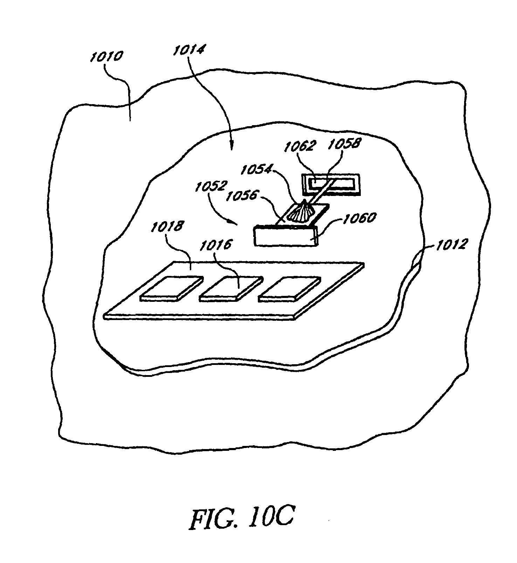

In an embodiment of the module **1052** illustrated in **FIG. 10B,** the solid XeF₂ **1054** is supported on the platform **1056.** In the illustrated embodiment, a faceplate **1060** is secured to the platform **1056.** The faceplate **1060** is sized and shaped to engage a matching opening (illustrated as part **1062** in **FIG. 10C**) in the sidewall **1012** of the chamber. In some embodiments, in the retracted position, the module **1052** is substantially sealed from the cavity **1014** of the chamber. For example, in some embodiments, the faceplate **1060** and/or the matching opening **1062** comprises a gasket and/or seal, which assists in substantially retaining XeF₂ and/or F₂ vapor from entering the chamber **1010** when the module **1052** is in the retracted position. In some embodiments, the module **1052** in the retracted position is not substantially sealed from the cavity **1014** of the chamber. In some embodiments, the module **1052** comprises a locking mechanism or mechanisms, useful for example, for maintaining the module in the retracted position and/or extended position. Suitable locking mechanisms are known in the art, for example, a latch between the faceplate **1060** and the sidewall **1012** of the chamber. In some embodiments, the locking mechanism is under automated control, for example, interlocked with the translation device **1036.**

The faceplate **1060** physically separates the inner region **1039** of the access port from the central cavity **1014** when the module **1052** is in the retracted position. In the illustrated embodiment, the inner region **1039** of the access port has a relatively small volume, and consequently, relatively poor mass transport characteristics. Even if the faceplate **1060** were absent, when the module **1052** is in the retracted position, XeF₂ vapor diffuses slowly into the central cavity **1014.** In the illustrated embodiment, the mass transport conditions translate into many minutes to hours for the partial pressure of XeF₂ to reach the equilibrium pressure of 3.8 Torr within the cavity **1014** with the module **1052** in the retracted position, even absent the faceplate **1060.**

In the embodiment illustrated in **FIG. 10B,** the platform **1056** of the XeF₂ module **1052** does not include sidewalls or a backwall, thereby reducing the number of barriers between the solid XeF₂ **1054** and the substrate **1016.** In other embodiments, the platform **1056** comprises one or more depressions and/or spoon-shaped areas in which the solid XeF₂ is placed. In some embodiments, the platform **1056** comprises one or more sidewalls and/or backwalls. In some embodiments, the platform **1056** comprises a grate and/or mesh, thereby providing improved mass transport through the platform **1056** by increasing the surface area of the solid etchant 1054 exposed the atmosphere. In some embodiments, the platform comprises a plurality of raised areas supporting the solid XeF₂ **1054,** for example a surface with corrugations and/or a raised grid. In some embodiments, the platform **1056** comprises a heater. Those skilled in the art will understand that in other embodiments, the platform **1056** has different configurations.

**FIG. 10C** is a cutaway view through the sidewall **1012** of the chamber **1010,** illustrating the XeF₂ module **1052** in an extended position. In the extended position, the XeF₂ module extends into the central cavity **1014** of the chamber. The translation stage **1036** is adjusted to extend the platform **1056** supporting the solid XeF₂ **1054** through an opening **1062** in the sidewall **1012** and into the central cavity **1014** of the chamber, thereby exposing the substrate **1016** to XeF₂ vapor.

In some embodiments, in the extended position, the module **1052** is proximate to the substrate **1016.** In some embodiments, the distance between the module **1052** and the substrate **1016** is not more than from about 1 cm to about 10 cm. In other embodiments, the distance is not more than about 0.5 cm, 2 cm, 3 cm, 4 cm, 5 cm, 6 cm, 7 cm, 8 cm, or 9 cm. For example, in some embodiments in which the substrate-to-be-etched is not larger than about 300 mm (8"), the distance is not greater than about 2 cm. In some embodiments in which the substrate-to-be-etched is at least about 300 mm, the distance is greater than about 5 cm. In other embodiments, the distance between the module **1052** and the substrate **1016** has another value. In the illustrated embodiment, the faceplate **1060** is situated between the module **1052** and the substrate **1016.** In other embodiments, the relative positions of the module **1052** and the substrate **1016** are different, for example with the module **1052** above or below the substrates, or to one side, such that the faceplate **1060** is not between the module **1052** and the substrate **1016.**

The illustrated embodiment eliminates the conduits and/or pipes between the solid XeF₂ and the substrates-to-be-etched, thereby provided improved mass transport compared to the apparatus **800** illustrated in **FIG. 8.** Furthermore, the disposition of the solid XeF₂ within the cavity **1014** permits the vapor pressure of the XeF₂ in the cavity **1014** to equilibrate rapidly.

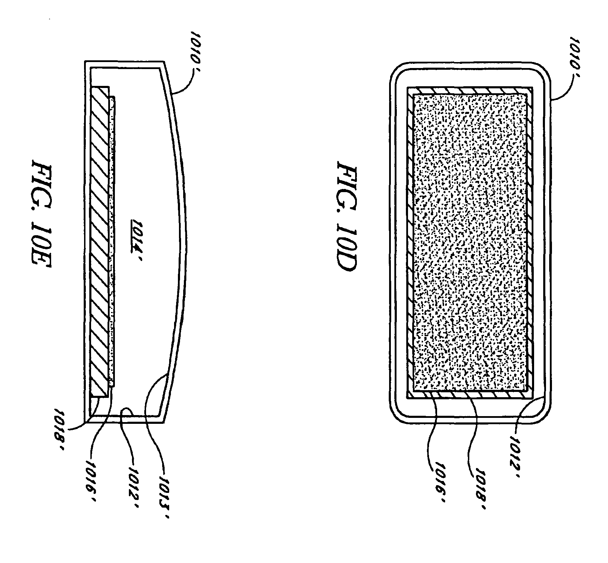

**FIG. 11A** illustrates a side view of an embodiment of a module **1152** in which the faceplate **1160** is pivotably attached to the platform **1156** using hinge **1164.** When the module **1152** is in the extended position, the faceplate **1160** pivots downwards around the hinge **1164** as illustrated in solid lines in **FIG. 11A**. When the module **1152** is retracted in direction y, the faceplate **1160** engages the opening in the sidewall (not illustrated), thereby pivoting the faceplate **1160** into the position illustrated in phantom in **FIG. 11A.**

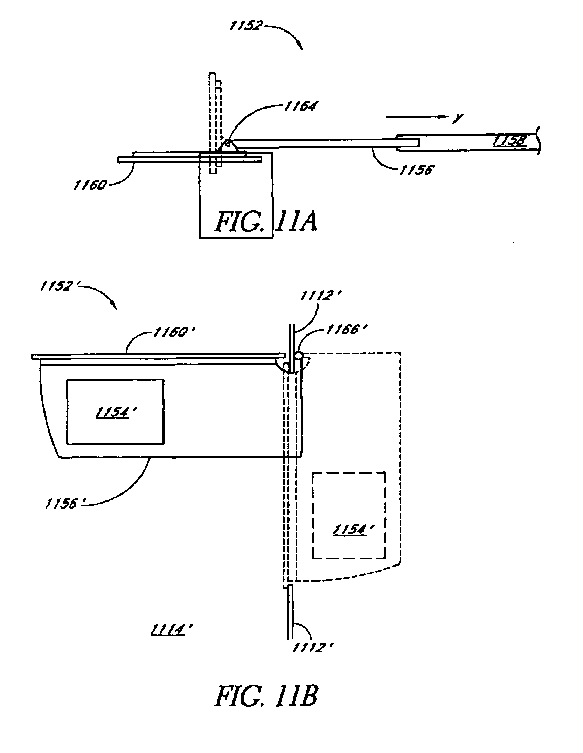

**FIG. 11B** illustrates a top view of an embodiment of a module **1152'** that pivotably moves from an extended position (solid lines) to a retracted position (phantom lines). In the illustrated embodiment, the module **1152'** comprises a platform **1156'** mounted to a pivot point **1166'.** A faceplate **1160'** is mounted to an edge of the platform **1156'.** Solid XeF₂ **1154'** is supported on the platform **1156'.** In the extended position, the XeF₂ **1154'** is positioned within the cavity **1114'** of the etching chamber. When the module **1152'** is pivoted into the retracted position, the faceplate **1160'** seals against an inner sidewall **1112'** of the chamber, thereby isolating the XeF₂ **1154'** from the cavity **1114'**.

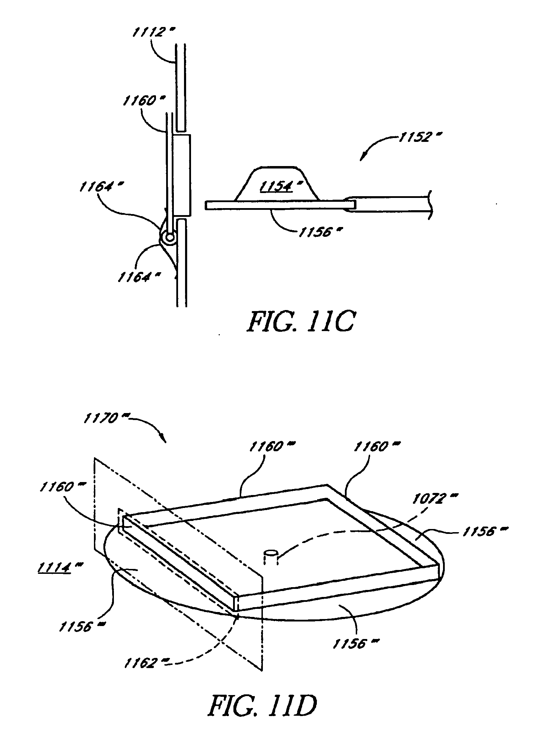

**FIG. 11C** illustrates a side view of an embodiment of a faceplate **1160"** pivotably mounted to the inner sidewall **1112"** of the chamber using hinges **1164".** In the illustrated embodiment, the module **1152"** does not comprise a faceplate. A spring **1168"** maintains the faceplate **1160"** in a closed position when the module **1152"** is in the retracted position. As the module **1152"** is extended, the platform **1156"** bears against and opens the faceplate **1160",** thereby permitting extension of the platform **1156"** and XeF₂ **1154"** into the cavity **1114".** In other embodiments, the faceplate **1160"** is maintained in a closed position by another means, for example, a mechanism that works in concert and/or interlocks with the mechanism that extends and retracts the module **1152".** Those skilled in the art will understand that other arrangements between the faceplate and sidewall are possible, for example, pivoting around an axis normal to the faceplate and sidewall, or in which the faceplate seals against the outer sidewall of the etching chamber. In other embodiments, the faceplate blocks and exposes the opening in the sidewall by sliding rather than by pivoting. Some embodiments comprise a plurality of faceplates. In some embodiments, the module is installed on the top or bottom of the etching chamber. In some embodiments, the apparatus comprises a plurality of modules.

**FIG. 11D** illustrates an embodiment comprising a turntable **1070"'** that comprises a plurality of platforms **1156'"** and faceplates **1160"'.** The illustrated turntable **1070"'** comprises four platforms **1156"'** and faceplates **1160"',** although those skilled in the art will understand that more or fewer platforms and/or faceplates are possible. Those skilled in the art will also understand that the number of modules and faceplates need not be equal. The turntable is rotatable around an axis **1072"'.** In use, a predetermined amount of solid XeF₂ is loaded on one or more of the platforms **1156'".** Rotating the turntable **1070"'** a predetermined angle around the axis **1072"'** moves one of the platforms **1156'"** into the cavity **1114"'** of the etching chamber. In the illustrated embodiment, the faceplate **1160'"** rotates into a position that occludes the opening **1162'"** in the sidewall. The embodiment illustrated in **FIG. 11D** is useful, for example, in processes that comprise a plurality of etching steps. Those skilled in the art will understand that the embodiments presented above are only exemplary and that any number of mechanisms are useful for moving a solid etchant into the etching chamber.

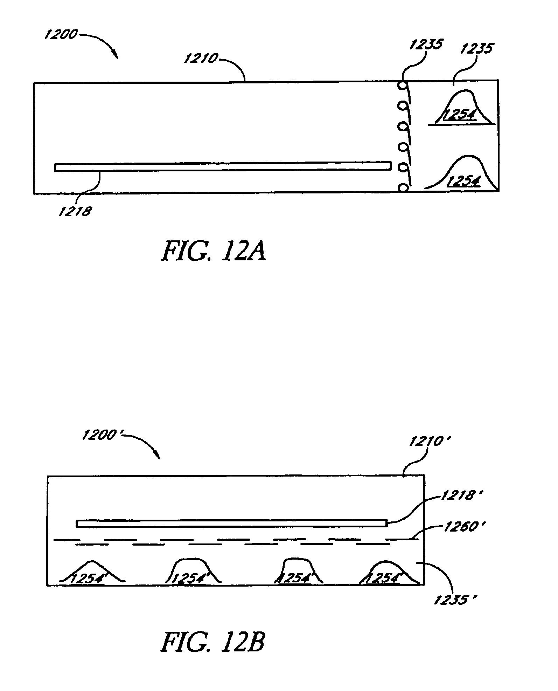

**FIG. 12A** illustrates in cross section an apparatus **1200** comprising an etching chamber **1210,** wherein the etching chamber **1210** comprises a substrate support **1218** and a solid etchant holding area **1235**. Solid XeF₂ **1254** is disposed in the solid etchant holding area **1235.** Disposed between the substrate support **1218** and the solid etchant holding area **1235** is a configurable partition **1260.** In the illustrated embodiment, the partition **1260** comprises a set of louvers. Closing the louvers substantially prevents XeF₂ vapor in the etchant holding area **1235** from reaching the substrate support **1218** and a substrate supported thereon **1216.** Opening the louvers permits XeF₂ vapor to etch the substrate **1216.** Those skilled in the art will understand that other mechanisms are useful for the configurable partition **1260,** for example, one or more shutters, gate valves, tambours and/or roll-tops, and the like. Those skilled in the art will understand that embodiments of the apparatus **1200** include other features described above.

**FIG. 12B** illustrates an embodiment of an apparatus 1200' in which the solid etchant holding area **1235',** the configurable partition **1260',** and solid XeF₂ **1254'** are disposed below the substrate support **1218'**. In the illustrated embodiment, the configurable partition 1260' comprises a set of shutters.

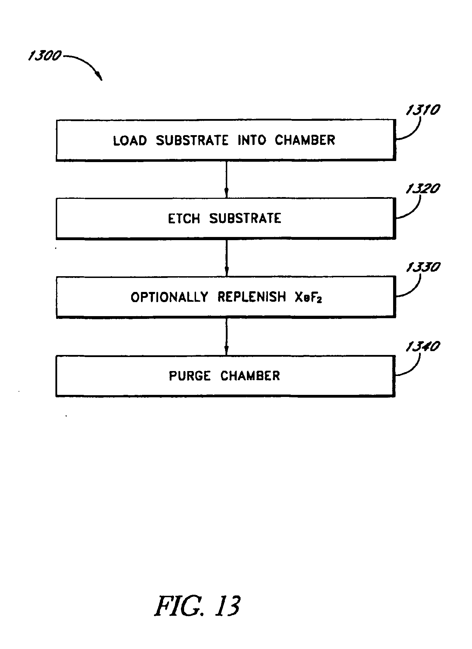

**FIG. 13** is a flowchart illustrating an embodiment of a method for processing a substrate with reference to the apparatus illustrated in **FIG. 10A-FIG. 10C.** Those skilled in the art will understand that other apparatus are also suitable for performing the method, including other apparatus disclosed herein. In step **1310,** the substrate **1016** is loaded into the chamber **1010.** Optionally, one or more processing steps not using XeF₂ are performed on the substrate **1016** in the etching chamber **1010.** The module **1052** is in the retracted position, thereby sealing the XeF₂ **1054** within the inner region **1039** of the access port, and preventing the entry of XeF₂ vapor into the cavity **1014.** The particular processing step will depend on the particular device under fabrication, the configuration of the etching chamber **1010,** and the particular process flow. An example of a suitable processing step includes depositing a layer or film, for example, a sacrificial layer, a mask, and/or a structural layer, using any method compatible with the configuration of the etching chamber **1010.** Examples of suitable methods include spin-coating, sputtering, physical vapor deposition, chemical vapor deposition, atomic layer deposition, molecular beam epitaxy, and the like. Examples of other processing steps include etching using an etchant other than XeF₂, cleaning, and the like.

Step **1320** is an etching step. In step **1320,** the XeF₂ module **1052** is extended into the central cavity **1014** of the etching chamber **1010** using the translation device **1036,** thereby exposing the substrate **1016** to XeF₂ vapor from the solid XeF₂ **1054.** The XeF₂ vapor etches materials and/or structures formed on the substrate **1016,** for example, a sacrificial layer in the fabrication of a MEMS device. The module **1052** is then retracted into the access port **1038.**

In some embodiments, the material and/or structure is a sacrificial layer used in the fabrication of an interferometric modulator. In some embodiments, the XeF₂ etch comprises a release etch that releases the secondary mirror/conductor **16** as discussed above and illustrated in **FIG. 6A**. In some embodiments, the XeF₂ vapor etches another material and/or structure used in the fabrication of a MEMS device, for example, an interferometric modulator.

Some embodiments use a predetermined amount of solid XeF₂ **1054** in the etching step. The amount of solid XeF₂ is determined, for example, from the type and amount of material-to-be-etched. For example, in some embodiments, the volume of the sacrificial layer-to-be-removed is known. An amount of solid XeF₂ **1054** is then selected sufficient to etch the sacrificial layer. In other embodiments, the thickness of the sacrificial layer is unknown. In some embodiments, the amount of solid XeF₂ **1054** is selected based on previous experience or on experimentation. In other embodiments, an amount of solid XeF₂ **1054** is selected such that substantially all of the solid XeF₂ sublimes, thereby filling the chamber with XeF₂ vapor at a partial pressure of about 3.8 Torr. Those skilled in the art will understand that amount of solid XeF₂ used in these embodiments depends on a variety of factors including the volume and temperature of the cavity.

In some embodiments, the progress of the release etch is monitored and the etching is terminated at a predetermined endpoint. In some embodiments, the monitoring is performed optically, for example, in the fabrication of an optical modulator. The monitoring is performed using any suitable device. In some embodiments, the monitoring is performed through a window in the etching chamber **1010.** In other embodiments, optical sensors are disposed within the etching chamber **1010.** In some embodiments, the reflectivity of the substrate is monitored. Those skilled in the art will understand that the reflectivity of the substrate will change as the release etch proceeds in the fabrication of an optical modulator. In some embodiments, the monitoring is performed at one or more wavelengths.

Some embodiments use another type of monitoring, for example, of the concentration of particular compounds in the etching chamber. For example, in some embodiments, the concentration of one or more etching byproducts is monitored. As discussed above, in some embodiments, the etching byproducts include MoF₆ and/or SiF₄. Those skilled in the art will understand that the particular byproducts will depend on factors including the composition of the particular substrate, as well as the materials used in the construction of the etching apparatus **1000.** In some embodiments, the etching byproducts are monitored spectroscopically using any method known in the art, for example, using infrared spectroscopy, UV-visible spectroscopy, Raman spectroscopy, and the like. In some preferred embodiments, the etching byproducts are monitored by mass spectroscopy. In some embodiments, the etching byproducts are monitored chromatographically, for example, by gas chromatography, liquid chromatography, and the like. In some embodiments, the disappearance of XeF₂ vapor is monitored, as discussed above for the monitoring of etching byproducts.

In some embodiments, the solid XeF₂ **1054** is monitored, for example, the weight, volume, and/or appearance.

Because XeF₂ is relatively expensive, in some embodiments, an amount of solid XeF₂ **1054** is loaded in the etching chamber such that substantially all of the solid XeF₂ **1054** is exhausted in the etching step **1320.** Moreover, unused solid XeF₂ **1054** remaining after completion of the etching step **1320** is likely contaminated with byproducts of the etching process, for example, MoF₆ and/or SiF₄, as well as contaminants entering the etching chamber **1010** in normal use, for example, organic contaminants. Consequently, in some embodiments, solid XeF₂ remaining after step **1320** is not reused.

In some embodiments, for example, where the amount of material-to-be-etched is relatively small, the material-to-be-etched is etched in a single exposure. The XeF₂ **module 1052** is extended into the chamber **1010** and remains therein until the XeF₂ vapor etches the material-to-be-etched, for example, one or more sacrificial layers, from the substrate **1016.** As described above, in some embodiments, the amount of solid XeF₂ **1054** is predetermined to perform the etch in a single step, and to be substantially exhausted in the etching step **1320**. Consequently, no additional portions of solid XeF₂ are added to the module **1052** in the etching of each batch of substrates in these embodiments.

In other embodiments, for example, where amount of material-to-be-etched is relatively large, the method **1300** comprises a plurality of etching steps **1320,** each of which comprises an extension of the XeF₂ module **1052** into the central cavity **1014** of the chamber and a retraction of the module **1052** into the access port **1038.** In some embodiments, the solid XeF₂ **1054** is not replenished on the module **1052** between etching steps **1320.**

In other embodiments, in optional step **1330,** the solid XeF₂ **1054** is replenished on the module **1052** between etching steps **1320.** In some embodiments, the module **1052** is retracted into the access port **1038** where additional solid XeF₂ **1054** is added to the platform **1056,** for example, using door **1050.** The module **1052** is then reextended into the central cavity **1014** of the chamber, whereupon additional etching occurs. The etching and replenishment is repeated as needed until the desired degree of etching is achieved. As discussed above, in some embodiments, the total amount of solid XeF₂ is predetermined to reduce waste of XeF₂.

In some embodiments, the etching step **1320** etches one layer from the substrate **1016.** In other embodiments, the etching step **1320** etches a plurality of layers from the substrate **1016.** For example, some embodiments of the fabrication of the device illustrated in **FIG. 6C** use a first sacrificial layer between the mirror **14** and **16,** and a second sacrificial layer above mirror **14.** In some embodiments, the layer or layers comprise substantially one material. In other embodiments, the layer or layers comprise a plurality of materials. In embodiments etching a plurality of layers, in some embodiments, the layers have substantially the same composition. In other embodiments, at least one of the layers has a different composition.

In some embodiments, the amount of solid XeF₂ used in step **1320** controls the degree of etching. Where the quantity of etchable material exceeds the amount of XeF₂, etching proceeds until the XeF₂ is substantially depleted. In some embodiments, this method etches a predetermined thickness of an etchable material.

In step **1340,** the chamber **1010** is purged. In some embodiments, the purge removes byproducts of the etching step **1320** from the central cavity **1014** of the etching chamber using the purge system **1020.** The particular etching byproducts depend on the particular materials etched in step **1320.** In some embodiments, the etching byproduct is MoF₆ and/or SiF₄. With reference to the etching chamber **1010** illustrated in **FIG. 10A,** some embodiments use a pump/backfill method to purge the cavity **1014.** The outlet valve **1034** is opened, thereby fluidly connecting the cavity **1014** of the chamber to the vacuum source. After a predetermined point, for example, time or pressure, the outlet valve **1034** is closed and the inlet valve **1030** opened, thereby filling the cavity **1014** with the purge gas. In some embodiments, the pump/backfill procedure is repeated one or more times. In other embodiments, opening valves **1030** and **1034** causes a purge gas to flow from the source of purge gas **1026** into the etch chamber **1010** through purge inlet **1022,** then out of the etch chamber **1010** through the purge outlet **1024** to the vacuum source **1032.** Some embodiments do not comprise a vacuum source, and the purge gas is exhausted from the apparatus **1000** through the purge outlet **1024** at substantially ambient pressure. Suitable purge gases are known in the art and are selected based on factors including the particular etching byproduct(s), the process steps preceding and/or following the etching step, the particular process flow, cost of the gas, and the like. Particular examples of purge gases are discussed above. In some embodiments, the chamber **1010** is purged after all of the solid XeF₂ **1054** in the module **1052** has been substantially exhausted.

Some embodiments comprise a single purge step **1340.** Other embodiments use a plurality of purge steps. In some embodiments, a plurality of purge steps **1340** are performed after the etching of the substrate is complete. As discussed above, some embodiments comprise a plurality of etching steps **1320.** Some of these embodiments comprise at least one purge step **1340** between two etching steps. Some embodiments comprise a purge step 1340 between each etching step. In some embodiments, a purge **1340** is performed substantially contemporaneously with step **1330** in which solid XeF₂ is replenished in the module **1052.**

For purposes of illustration, a description of method **1300** with reference to the apparatus in **FIG. 12A** is as follows. Because the method is substantially as described above, the following description focuses on differences. In optional step **1310,** the configurable partition **1260** is closed and the substrate **1216** is subjected to another processing step. In step **1320,** the configurable partition **1260** is opened and the substrate **1216** exposed to XeF₂ vapor formed by the solid XeF₂ in the etchant holding area **1235.** In optional step **1330,** the etchant holding area **1235** is replenished with solid XeF₂. In step **1340,** the chamber 1210 is purged.

### EXAMPLE I

An array of modulators at the stage illustrated in **FIG. 7D** are fabricated according to the method described in U.S. Published Application 2004/0051929 on a 200-mm diameter glass substrate. The sacrificial layer is molybdenum. The substrate is loaded onto a fused silica substrate support in a stainless steel etching chamber with internal dimensions of 220 mm by 400 mm by 70 mm. The bottom of the etching chamber is equipped with a fused silica window. The etching chamber is also equipped with a port to a mass spectrometric (MS) detector and an etchant unit as illustrated in **FIG. 10A-FIG. 10C.**

The etching chamber is purged three times by evacuating to 10⁻² torr and backfilling with nitrogen gas at ambient pressure. XeF₂ (8.5 g, 50 mmol) is loaded onto the etchant unit and the unit purged with nitrogen. The module is then extended into the etching chamber. The progress of the etching is monitored optically through the window, as well as using the MS. The etching is complete when color of the substrate changes from grey to uniformly white and the concentration of MoF₆ as detected by the MS levels off.

Those skilled in the art will understand that changes in the apparatus and manufacturing process described above are possible, for example, adding and/or removing components and/or steps, and/or changing their orders. Moreover, the methods, structures, and systems described herein are useful for fabricating other electronic devices, including other types of MEMS devices, for example, other types of optical modulators.

Moreover, while the above detailed description has shown, described, and pointed out novel features of the invention as applied to various embodiments, it will be understood that various omissions, substitutions, and changes in the form and details of the device or process illustrated may be made by those skilled in the art without departing from the spirit of the invention. As will be recognized, the present invention may be embodied within a form that does not provide all of the features and benefits set forth herein, as some features may be used or practiced separately from others.

## Claims

1. An apparatus for etching comprising:
means for housing a substrate to be etched,
means for supporting the substrate;
means for supporting an etchant; and
a means for positioning the substrate supporting means and the etchant supporting means in close proximity within the housing means.

2. The apparatus of claim 1, wherein the housing means comprises an etching chamber.

3. The apparatus of claims 1 or 2, wherein the substrate supporting means comprises a support for the substrate to be etched.

4. The apparatus of claims 1, 2, or 3, wherein the etchant supporting means comprises an etchant module.

5. The apparatus of claims 1, 2, 3, or 4, wherein the positioning means comprises a translation device.

6. The apparatus of claim 4, wherein the etchant module is movable between a retracted position and an extended position, in the retracted position, the etchant module is substantially outside the etching chamber, and in the extended position, the etchant module is substantially within the etching chamber.

7. The apparatus of claim 6, further comprising a faceplate, wherein the faceplate seals the etching chamber from the etchant module when the etchant module is in the retracted position.

8. The apparatus of claim 6, wherein the movement of the module between the extended and the retracted position is automated.

9. The apparatus of claim 6, wherein the etching chamber comprises stainless steel.

10. The apparatus of claim 6, further comprising an optical sensor configured to detect a reflectance of the substrate on the substrate support.

11. The apparatus of claim 6, wherein the etchant module comprises a platform configured to support solid xenon difluoride.

12. The apparatus of claim 11, further comprising solid xenon difluoride.

13. The apparatus of claim 6, wherein the substrate supporting means and the etchant module are not more than about 10 cm apart when positioned in close proximity.

14. The apparatus of any one of claims 1-13, further comprising a purge system.

15. The apparatus of claim 1, wherein the substrate is configured to be part of a microelectromechanical systems device;

16. The apparatus of claim 15, wherein the microelectromechanical systems device is an optical modulator.

17. The apparatus of claim 12, wherein the substrate supporting means and the solid xenon difluoride are sufficiently proximate when positioned in close proximity for a vapor formed from the solid xenon difluoride to etch the substrate.

18. A method for fabricating a microelectromechanical systems device comprising:
supporting a substrate comprising an etchable material within an etching chamber; and
positioning within the etching chamber a solid etchant, wherein the solid etchant forms a gas-phase etchant capable of etching the etchable material.

19. The method of claim 18, further comprising supporting the solid etchant on an etchant module, wherein positioning within the etching chamber a solid etchant comprises extending the etchant module into the etching chamber.

20. The method of claims 18 or 19, wherein the solid etchant is solid xenon difluoride.

21. The method of claims 18, 19, or 20, wherein the etchable material comprises molybdenum.

22. The method of claims 18, 19, 20 or 21, wherein the etchable material comprises silicon.

23. The method of claims 18, 19, 20, 21 or 22, further comprising monitoring the progress of the etching using an optical sensor configured to detect the reflectance of a substrate.

24. The method of claims 18, 19, 20, 21, 22, or 23, wherein the substrate and the solid etchant are not more than about 10 cm apart when positioned within the etching chamber.

25. The method of claims 18, 19, 20, 21, 22, 23, or 24, wherein the microelectromechanical systems device is an optical modulator.

26. A microelectromechanical systems device fabricated according the method of any one of claims 18-25.
